Europäisches Patentamt

European Patent Office

Office européen des brevets

(11) Publication number: **0 458 285 A1**

(12) **EUROPEAN PATENT APPLICATION**

(21) Application number: 91108215.4

(51) Int. Cl.5: **H03M 13/00**

(22) Date of filing: 22.05.91

(30) Priority: 22.05.90 JP 132007/90

(43) Date of publication of application:
27.11.91 Bulletin 91/48

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken(JP)**

(72) Inventor: **Koyama, Katsuhiko**
**378-305, Kamikurata-cho, Totsuka-ku**
**Yokohama-shi, Kanagawa-ken(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) **Error location and error pattern calculation circuit.**

(57) In the error location and error pattern calculating circuit, a polynominal $\sigma(\alpha i)$ is obtained by a first polynominal calculating circuit; (A); a polynominal $\eta(\alpha i)$ is obtained by a second polynominal calculating circuit (B); and a polynominal $\sigma'(\alpha i)/\alpha i^k$ or $\alpha i^k/\sigma'(\alpha i)$ is obtained by a third polynominal calculating circuit (C). The outputs of the second and third polynominal calculating circuits (B, C) are both given to a Galois field arithmetic circuit (E) to form a numerical value $Ei = \alpha i^k \cdot \eta(\alpha i)/\sigma'(\alpha i)$. If the output of the first polynominal calculating circuit (A) is determined as 0 by a detecting circuit (D), the numerical value $i$ at this time is determined to be an error location, and a pattern $Ei$ corresponding to the numerical value $i$ is determined to be an error pattern simultaneously. The above-mentioned operations are all executed by hardware to reduce the time required for error correction.

F I G . I

BACKGROUND OF THE INVENTION

The present invention relates to an error location and error pattern calculating circuit, and more specifically to an apparatus for correcting error on the basis of Reed-Solomon code, which is suitable for an optical disk system, in particular.

Conventionally, where an error is corrected by use of Reed-Solomon code, a reproduced data read from recorded data is divided by a generator polynominal to obtain a residue with hardware, and then an error location and an error pattern and both so far obtained on the basis of the residue in accordance with software processing. In the conventional method, however, there exists a problem in that long time is required for the software processing when the reproduced data include many erroneous data.

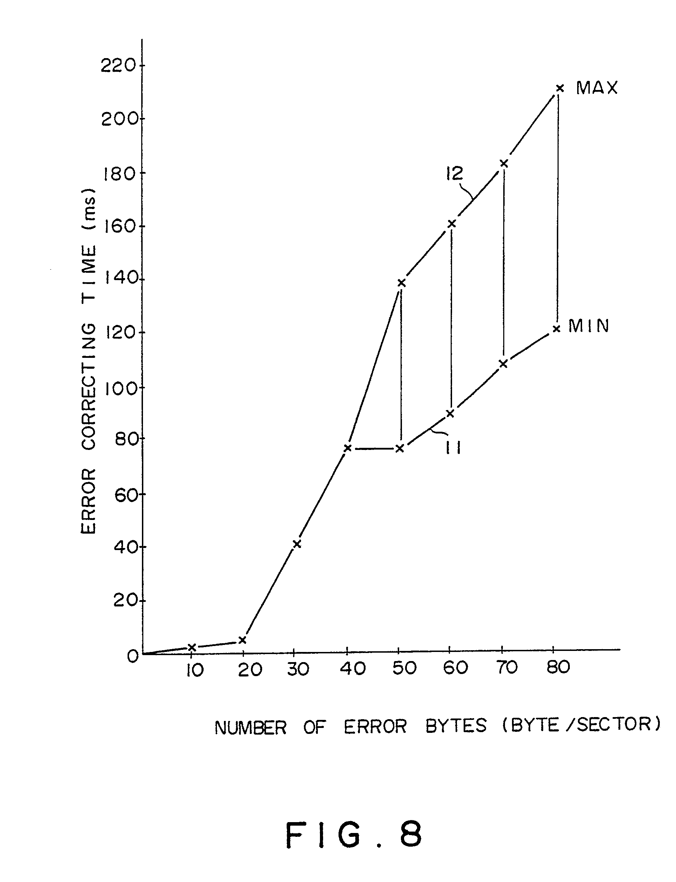

Fig. 8 shows the relationship between the number of erroneous data bytes per sector and the time required for error correction, by way of example, obtained when data recorded in a 5.25-inch dia. optical disk of ISO format are reproduced. In Fig. 8, the lines 11 indicates the minimum values obtained when the number of erroneous data is 40 byte/sector or more, and the lines 12 indicates the maximum values obtained under the same conditions. Therefore, the error correcting time ranges between these two minimum and maximum lines. Fig. 8 indicates that the error correcting time increases sharply when the number of erroneous data is 20 byte/sector or more. For instance, if the data length is 1024 byte/sector and the number of interleaves is 10, the error correcting time ranges from 120 to 210 ms when the number of erroneous data is 80 byte/sector. Therefore, where the optical disk rotates at speed of 1800 r.p.m., there exists a problem in that the optical disk makes 3 to 6 revolutions during error correction, thus resulting in an idle disk revolution.

With the advance of recent higher integration technology, computation so far processed in accordance with software is executed by hardware more and more and therefore the processing time has been reduced markedly. In other words, for instance, error correction is now being executed by providing a residue forming circuit for obtaining a residue by dividing a reproduced data by a formed polynominal, a syndrome forming circuit, a Chien search circuit, etc. in combination with each other.

In more detail, in the above example, a residue is obtained by the residue generating circuit, and a syndrome is formed by the syndrome generating circuit; Euclid's algorithm is applied to the formed syndrome to obtain an error location polynominal and an error pattern polynominal; and the obtained error location polynominal is inputted to the Chien search circuit for searching a solution by substituting the numerical value for the polynominal, in order to obtain an error location corresponding to a solution of the error location equation. Further, an error pattern corresponding to the obtained error location is calculated in accordance with the error pattern polynominal, in order to correct the error.

In the conventional method, however, since the steps, at which the error location polynominal and the error pattern polynominal are obtained in accordance with Euclid's algorithm and the error pattern is obtained, are processed by means of software or a control circuit including Galois field arithmetic logic unit and using microprograms, it takes a long time from when an error location is obtained by chain searching operation of the Chien search circuit to when an error pattern value is obtained.

SUMMARY OF THE INVENTION

Therefore, the object of the present invention is to provide an error location and error pattern correcting calculating circuit which can correct error at high speed.

According to the present invention, there is provided an error location and error pattern calculating circuit by which a pattern Ei in Euclid's algorithm is expressed as

$$Ei = \alpha i^{k} \cdot \eta(\alpha i)/\sigma'(\alpha i)$$

by a pattern polynominal $\sigma(z)$, a polynominal $\sigma'(z)$ obtained by differentiating the polynominal $\sigma(z)$, a polynominal $\eta(z)$, a numerical value i, Galois field elements $\alpha i$, and an integer k determined by the generator polynominals as $\ell + m$ where $\ell$ and $m$ are both integers, which comprises:
a first polynominal calculating circuit for calculating and outputting the polynominal $\sigma(\alpha i)$;
a detecting circuit for detecting that said first polynominal calculating circuit outputs 0;
a second polynominal calculating circuit for calculating and outputting the polynominal $\alpha i^{\ell} \cdot \eta(\alpha i)$;
a third polynominal calculating circuit for calculating and outputting the polynominal $\sigma'(\alpha i)/\alpha i^{m}$; and
a Galois field arithmetic circuit for executing Galois field operation on the basis of outputs of said second and third polynominal calculating circuits and forming and outputting the numerical value Ei, and wherein a numerical value i obtained when said detecting circuit detects 0 is determined as an error location, and a numerical value Ei corresponding to this numerical value i is determined as an error pattern.

According to the present invention, a polynominal $\sigma(\alpha i)$ is obtained by a first polynominal calculating circuit and outputted therefrom; a polynominal $\eta(\alpha i)$ is obtained by a second polynominal calculating circuit and outputted therefrom; and a polynominal $\sigma'(\alpha i)/\alpha i^k$ or $\alpha i^k/\sigma'(\alpha i)$ is obtained by a third polynominal calculating circuit and outputted therefrom. The outputs of the second and third polynominal calculating circuits are given to a Galois arithmetic circuit, and a Galois field is calculated to form a numerical value Ei. On the other hand, a detecting circuit discriminates whether the output of the first polynominal calculating circuit is "0" or not. If "0", a numerical value i is determined to be an error location, and further a numerical value Ei corresponding to the numerical value i is determined to be an error pattern. In the correcting circuit according to the present invention, as described above, since three polynominal calculating circuits are provided, an error pattern can be obtained simultaneously when an error position is obtained. Additionally, since these operations are executed by hardware circuits, it is possible to reduce time required for error correction.

## BRIEF DESCRIPTION OF THE DRAWINGS

In the attached drawings,

Fig. 1 is a block diagram showing an embodiment of the error location and error pattern calculating circuit according to the present invention;

Fig. 2 is a flowchart showing Euclid's algorithm adopted for the present invention;

Fig. 3 is a block diagram showing the polynominal calculating circuit A and the detecting circuit D shown in Fig. 1;

Fig. 4 is a block diagram showing the polynominal calculating circuit B shown in Fig. 1;

Fig. 5 is a block diagram showing the polynominal calculating circuit C shown in Fig. 1;

Fig. 6 is a block diagram showing the Galois field calculating circuit E shown in Fig. 1;

Fig. 7 is a graphical representation showing the relationship between the error correcting time and the number of error bytes obtained when an embodiment of the error location and error pattern calculating circuit according to the present invention is adopted; and

Fig. 8 is a graphical representation showing the relationship between the error correcting time and the number of error bytes obtained in the prior-art circuit.

## DETAILED DESCRIPTION OF THE PREFERRED EMBODIMENTS

In general, an error is corrected in accordance with the following steps:

(1) a residue is obtained on the basis of a reproduced data and by means of a residue generating circuit;

(2) a syndrome is determined on the basis the obtained residue and by means of a syndrome generating circuit;

(3) an error location polynominal and an error pattern polynominal are obtained on the basis of the determined syndrome and by means of the Euclid's algorithm; and

(4) an error location and an error pattern are obtained on the basis of the error location polynominal and the error pattern polynominal.

The present invention relates to the above step (4) at which an error location and an error pattern are obtained. The process from steps (1) to (4) will be first explained hereinbelow.

In the same way as in the conventional method, a residue is obtained in step (1), and a syndrome is determined on the basis of the obtained residue in step (2). In step (3), if the determined syndrome is S0, S1, ... S2t-1, the syndrome polynominal S(z) is expressed as

$$S(z) = -\sum_{j=0}^{2t-1} Sj \cdot Zj \qquad \ldots (1)$$

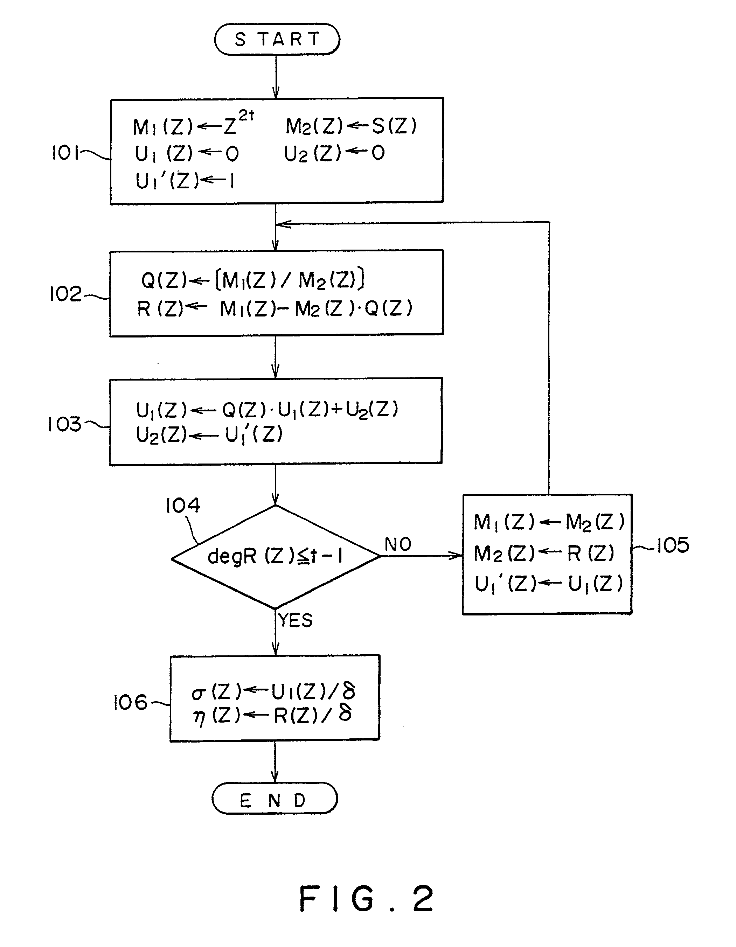

Further, an error position polynominal and an error numerical value polynominal are obtained on the basis of the syndrome polynominal S(z) in accordance with the Euclid's algorithm shown in Fig. 2. That is, U1(z) and U2(z) are both initialized; 1 is substituted for U'(z) obtained by differentiating U(z); $Z^{2t}$ is substituted for M1(z); and S(z) is substituted for M2(z) (in step 101). M1(z) is divided by M2(z) to obtain a quotient Q(z) and a residue R(z) (in step 102).

U2(z) is added to Q(z)•U(z) to obtain U1(z), and this U1(z) is differentiated to obtain U2(z) (in step 103).

R(z) is discriminated as to whether the degree of R(z) is t-1 or less (in step 104). If the degree is more than t-1, M2(z) is substituted for M1(z); R(z) is substituted for M2(z); and U1(z) is substituted for u1'(z), respectively (in step 105). If the degree is less than t-1, U1(z)/$\delta$ is substituted for $\sigma$(z); and R(z)/$\delta$ is substituted for $\eta$(z), respectively to end the procedure (in step 106). Here, $\delta$ denotes the coefficient of the maximum degree of U1(z).

The $\sigma$(z) thus obtained in accordance with the above Euclid's algorithm corresponds to the error location polynominal, and the obtained $\eta$(z) corresponds to the error pattern polynominal, respectively.

Further, in step (4), an error location and an error pattern can be obtained on the basis of the above expressions as follows:

If each element of a Galois field corresponding to the error location i is $\alpha i$, the error pattern Ei is expressed in general as

$$Ei = \alpha i^{k} \cdot \eta(\alpha i)/\sigma'(\alpha i) \quad (2)$$

where k denotes an integer determined by the generator polynominals.

Subsequently, when $\alpha i^{k}$ is incorporated in a polynominal $\eta(\alpha i)$ calculating circuit, a $\sigma'(\alpha i)$ calculating circuit or $\eta(\alpha i)$ and $\sigma'(\alpha i)$ calculating circuits for transformation and further the polynominals are expressed as $X(\alpha i)$ and $Y(\alpha i)$, and an operation is expressed as o, the expression (2) can be expressed as

$$Ei = X(\alpha i)oY(\alpha i) \quad (3)$$

For instance, if $\alpha i^{k}$ is incorporated in $\sigma'(\alpha i)$, the expression (2) can be expressed as

$$Ei = \eta(\alpha i)/\{\sigma'(\alpha i)/\alpha i^{k}\} \quad (4)$$

where $X(\alpha i)$ and $Y(\alpha i)$ are

$$X(\alpha i) = \eta(\alpha i) \quad (5)$$

$$Y(\alpha i) = \sigma'(\alpha i)/\alpha i^{k} \quad (6)$$

The above expression (4) indicates a division of polynominal operation.

On the other hand, when $\alpha i^{k}$ is incorporated in $\eta(\alpha i)$, the expression (2) can be expressed as

$$Ei = \{\alpha i^{k} \cdot \eta(\alpha i)\}/\sigma'(\alpha i) \quad (7)$$

where $X(\alpha i)$ and $Y(\alpha i)$ are

$$X(\alpha i) = \alpha i^{k} \cdot \eta(\alpha i) \quad (8)$$

$$Y(\alpha i) = \sigma'(\alpha i) \quad (9)$$

The above expression (7) also indicates division. Further, when $\alpha i^{k}$ is incorporated in $\sigma'(\alpha i)$ and further the expression (2) is transformed as

$$Ei = \eta(\alpha i) \cdot \{\alpha i^{k}/\sigma'(\alpha i)\} \quad (10)$$

$X(\alpha i)$ and $Y(\alpha i)$ are

$$X(\alpha i) = \eta(\alpha i) \quad (11)$$

$$Y(\alpha i) = \alpha i^{k}/\sigma'(\alpha i) \quad (12)$$

The above expression (10) indicates multiplication.

4

Further, when $\alpha i^{1+m}$ is incorporated in $\eta(\alpha i)$ and $\sigma'(\alpha i)$, separately by determining $k = 1+m$, where 1 and m are both integers, the expression (2) can be expressed as

$$Ei = \{\alpha i^1 \cdot \eta(\alpha i)\}/\{\sigma'(\alpha i)/(\alpha i^m)\} \quad (13)$$

where $X(\alpha i)$ and $Y(\alpha i)$ are

$$X(\alpha i) = \alpha i^1 \cdot \eta(\alpha i) \quad (14)$$

$$Y(\alpha i) = \sigma'(\alpha i)/\alpha i^m \quad (15)$$

The above expression (13) indicates a division.

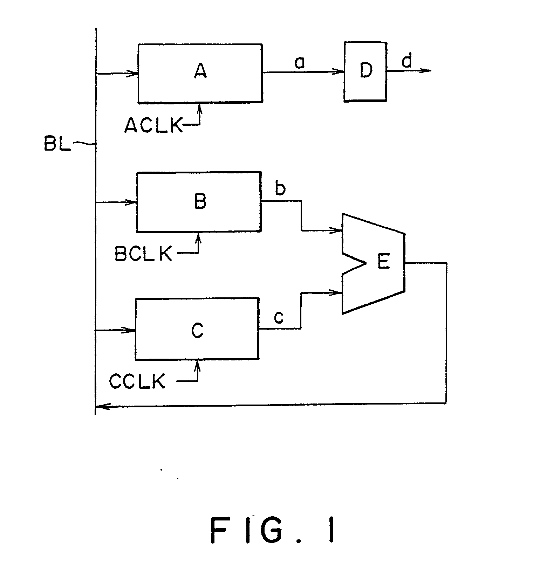

Fig. 1 shows a configuration of an embodiment of the error location and error pattern calculating circuit according to the present invention. The calculating circuit comprises a polynominal calculating circuit A having an input terminal connected to a bus line BL and a clock terminal for receiving ACLK, for calculating $\sigma(\alpha i)$; a detecting circuit D connected to an output terminal of the calculating circuit A, for detecting a zero output of the calculating circuit A; a polynominal calculating circuit B having an input terminal connected to the bus line BL and a clock terminal for receiving BCLK, for calculating the polynominal $X(\alpha i)$; a polynominal calculating circuit C having an input terminal connected to the bus line BL and a clock terminal for receiving CCLK, for calculating the polynominal $Y(\alpha i)$; and a Galois field arithmetic circuit E connected to both the outputs of the calculating circuits B and C, for executing Galois field operation o and outputting the operation result to the bus line BL.

The calculating operation of the embodiment thus configured will be described hereinbelow. First, the polynominal calculating circuits A, B and C are initialized to their respective initial values. Under these conditions, if the detecting circuit D detects that the output of the polynominal calculating circuit A is 0, a numerical value i at this time corresponds to an error location, and an output Ei of the Galois field arithmetic circuit Ei corresponds to an error pattern. In usual, since i is 0 at initialization, 0 is an error location and Eo is an error pattern.

At the succeeding step, clocks ACLK, BCLK and CCLK are inputted to the polynominal calculating circuits A, B and C, respectively. If the detecting circuit detects 0 in response to the numerical value i at this time, this numerical value i indicates an error location, and an output Ei of the Galois field arithmetic circuit E indicates an error pattern.

As described above, whenever clocks ACLK, BCLK and CCLK are inputted to the polynominal calculating circuits A, B and C, respectively in sequence, it is possible to simultaneously obtain an error location i and an error pattern Ei corresponding to the error location i.

The operation procedure for correcting an error location and an error pattern will be explained hereinbelow by taking the case where data recorded on a 5.25-inch optical disk system conforming to ISO standard are reproduced. Here, the primitive polynominal Gp(x) of the optical disk, the elements $\alpha i$ of the Galois field, and the generator polynominal G(x) are defined as follows:

$$Gp(x) = X^8 + X^5 + X^3 + X^2 + 1 \quad (16)$$

$$\alpha^i = (\beta^i)^{88} \quad (17)$$

$$G(x) = (x+\alpha^{120}) \times (x+\alpha^{121}) \times \ldots$$
$$\ldots \times (x+\alpha^{134}) (x+\alpha^{135}) \quad (18)$$

where $\beta$ denotes an primitive element of Gp(x).

Further, the syndrome generating circuit forms syndrome S0, S1, ... S14, S15 in correspondence to $\alpha^{120}, \alpha^{121}, \ldots \alpha^{134}, \alpha^{135}$. In this example, the syndrome polynominal can be expressed as

$$S(z) = -\sum_{j=0}^{15} S_j \cdot z^j \qquad \ldots (19)$$

By applying the afore-mentioned Euclid's algorithm to S(z) of expression (19) at t = 8, an error location polynominal $\sigma(z)$ and an error pattern polynominal $\eta(z)$ can be obtained as

$$\sigma(z) = \sigma_8 \cdot z^8 + \sigma_7 \cdot z^7 + \ldots + \sigma_1 z + \sigma_0 \quad (20) \quad \eta(z) = \eta_7 \cdot z^7 + \eta_6 \cdot z^6 + \ldots + \eta_1 \cdot z + \eta_0 \quad (21)$$

If the above expression $\sigma(z)$ is differentiated, the following expression can be obtained:

$$\begin{aligned}
\sigma'(z) &= 8\sigma_8 \cdot z^7 + 7\sigma_7 \cdot z^6 + 6\sigma_6 \cdot z^5 + \\
&\quad \ldots + 2\sigma_2 z + \sigma_1 \\
&= \sigma_7 \cdot z^6 + \sigma_5 \cdot z^4 + \sigma_3 \cdot z^2 + \sigma_1 \qquad \ldots \quad (22)
\end{aligned}$$

If a Galois field element $\alpha i$ corresponding to the error location i is substituted for each z of the expressions (20), (21) and (22),

$$\sigma(\alpha i) = \sigma_8 (\alpha i)^8 + \sigma_7 (\alpha i)^7 + \ldots + \sigma_1 (\alpha i) + \sigma_0 \quad (23)$$

$$\eta(\alpha i) = \eta_7 \cdot (\alpha i)^7 + \eta_6 \cdot (\alpha i)^6 + \ldots + \eta_{11} \cdot (\alpha i) + \eta_0 \quad (24)$$

$$\sigma'(\alpha i) = \sigma_7 \cdot (\alpha i)^6 + \sigma_5 \cdot (\alpha i)^4 + \sigma_3 \cdot (\alpha i)^2 + \sigma_1 \quad (25)$$

Further, since $\alpha i = \alpha^{-i}$,

$$\sigma(\alpha i) = \sigma_8 \cdot (\alpha^{-8})^i + \sigma_7 \cdot (\alpha^{-7})^i + \ldots + \sigma_1 \cdot (\alpha^{-1})^i + \sigma_0 \cdot (\alpha^0)^i \quad (26)$$

$$\eta(\alpha i) = \eta_7 \cdot (\alpha^{-7})^i + \eta_6 \cdot (\alpha^{-6})^i + \ldots + \eta_1 \cdot (\alpha^{-1})^i + \eta_0 \cdot (\alpha^0)^i \quad (27)$$

$$\sigma'(z) = \sigma_7 \cdot (\alpha^{-6})^i + \sigma_5 \cdot (\alpha^{-4})^i + \sigma_3 \cdot (\alpha^{-2})^i + \sigma_1 \cdot (\alpha^0)^i \quad (28)$$

In the case of the 5.25-inch optical disk, since k is 119 in expression (2), the error pattern value Ei is

$$Ei = \alpha i^{119} \cdot \eta(\alpha i)/\sigma'(\alpha i) \quad (29)$$

In the expression (29), when $\alpha i^{119}$ is incorporated in $\sigma'(\alpha i)$ to transform it to the form of expression (4), the expressions (29), (27) and (28) are expressed as

$$Ei = \eta(\alpha i)/\{\sigma'(\alpha i)/\alpha i^{119}\} \quad (30)$$

$$X(\alpha i) = \eta(\alpha i) = \eta_7 \cdot (\alpha i)^7 + \eta_6 \cdot (\alpha i)^6 +$$
$$\cdots + \eta_1 \cdot (\alpha i) + \eta_0$$
$$= \eta_7 \cdot (\alpha^{-7})^i + \eta_6 \cdot (\alpha^{-6})^i +$$
$$\cdots + \eta_1 \cdot (\alpha^{-1})^i + \eta_0 \cdot (\alpha^0)^i \qquad \cdots \ (31)$$
$$Y(\alpha i) = \sigma'(\alpha i)/\alpha i^{119}$$
$$= \{\sigma_7 \cdot (\alpha i)^6 + \sigma_5 \cdot (\alpha i)^4 + \sigma_3 \cdot (\alpha i)^2 + \sigma_1\}/\alpha i^{119}$$
$$= \sigma_7 \cdot (\alpha i)^{-113} + \sigma_5 \cdot (\alpha i)^{-115} + \sigma_3 \cdot (\alpha i)^{-117}$$
$$+ \sigma_1 \cdot (\alpha i)^{-119}$$
$$= \sigma_7 \cdot (\alpha^{113})^i + \sigma_5 \cdot (\alpha^{115})^i + \sigma_3 \cdot (\alpha^{117})^i$$
$$+ \sigma_1 \cdot (\alpha^{119})^i \qquad \cdots \ (32)$$

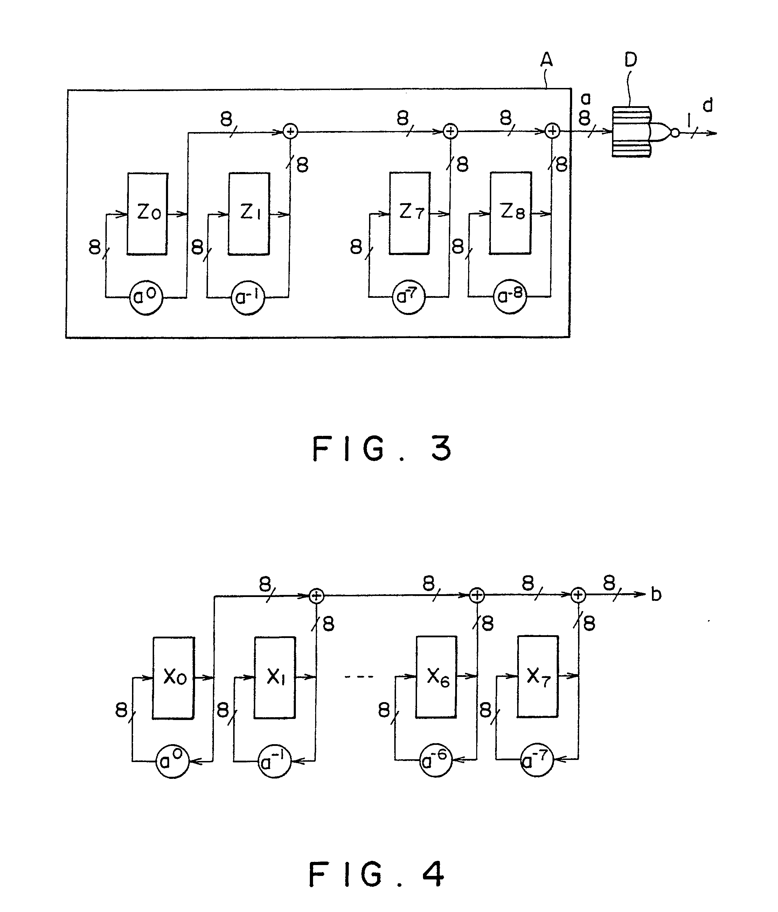

Fig. 3 shows the polynominal calculating circuit /a for calculating $\sigma(\alpha i)$ and the detecting circuit D in further detail, both shown in Fig. 1.

First, $\sigma_0$, $\sigma_1$, ... $\sigma_7$, $\sigma_8$ are set to registers $Z_0$, $Z_1$, ..., $Z_7$, $Z_8$ in sequence as an initial value, respectively. In Fig. 3, $\alpha^0$, $\alpha^{-1}$, ... $\alpha^{-7}$, $\alpha^{-8}$ denote $\alpha i$ multiplication circuits respectively, each of which is composed of a mapped ROM and an exclusive OR gate. The respective calculated results are inputted to the respective exclusive OR gates and the polynominal calculating circuit A outputs a polynominal $\sigma(\alpha_0)$ as

$$\sigma(\alpha 0) = \sigma_0 + \sigma_1 + \cdots + \sigma_7 + \sigma_8$$
$$= \sigma_0(\alpha^0)^0 + \sigma_1(\alpha^{-1})^0 + \cdots + \sigma_7(\alpha^{-7})^0$$
$$+ \sigma_8(\alpha^{-8})^0 \qquad \cdots \ (33)$$

The detecting circuit D composed of 8-input NOR gate D discriminates whether the output of the circuit A is 0 or not. If $\sigma(\alpha 0)$ is 0, a data 1 is outputted from an output terminal d thereof, and the location 0 at this time is an error location. If $\sigma(\alpha 0)$ is not 0, 0 is outputted.

Whenever a single clock ACLK is inputted to the registers $Z_0$, $Z_1$, ... $Z_7$, $Z_8$, respectively, the respective outputs $\sigma_0\alpha^0$, $\sigma_1\alpha^{-1}$, ... $\sigma_7\alpha^{-7}$, $\sigma_8\alpha^{-8}$ of the respective multiplication oircuits $\alpha^0$, $\alpha^{-1}$, ... $\alpha^{-7}$, $\alpha^{-8}$ are held in the respective registers, separately. Therefore, the output of the polynominal calculating circuit A via the output terminal a is

$$\sigma(\alpha 0) = \sigma_0\alpha^0 + \sigma_1\alpha^{-1} + \cdots + \sigma_7\alpha^{-7} + \sigma_8\alpha^{-8}$$
$$= \sigma_0(\alpha^0)^1 + \sigma_1(\alpha^{-1})^1 + \cdots + \sigma_7(\alpha^{-7})^1$$
$$+ \sigma_8(\alpha^{-8})^1 \qquad \cdots \ (34)$$

Similarly, the detecting circuit D discriminates whether the output $\sigma(\alpha 1)$ is 0 or not. If 0, 1 is outputted from the output terminal d, and the location 1 at this time is an error location. If the output $\sigma(\alpha 1)$ is not 0, 0 is outputted.

In response to the first clock, the registers $Z_0$, $Z_1$, ... $Z_7$, $Z_8$ store $\sigma_0(\alpha^0)^i$, $\sigma_1(\alpha^{-1})^i$, ... $\sigma_7(\alpha^{-7})^i$, $\sigma_8(\alpha^{-8})^i$ in sequence, respectively, so that the output from the output terminal a is

$$\sigma(\alpha i) = \sigma_0(\alpha^0)^i + \sigma_1(\alpha^{-1})^i +$$
$$\cdots + \sigma_7(\alpha^{-7})^i + \sigma_8(\alpha^{-8})^i \quad (35)$$

The detecting circuit D discriminates whether the output $\sigma(\alpha i)$ is 0 or not. If 0, 1 is outputted from the output terminal d, and the location i is an error location. If the output $(\alpha i)$ is not 0, 0 is outputted.

In the same way, calculating operations are continued by inputting the clock to the registers $Z_0$, $Z_1$, ... $Z_7$, $Z_8$ one by one. As described above, the calculation operations discriminate whether the loction i is an error location or not at each location i.

Fig. 4 shows the polynominal calculating circuit B for calculating $X(\alpha i)$ $(= \eta(\alpha i))$, which is shown in Fig. 1.

First, $\eta_0, \eta_1, \ldots \eta_6, \eta_7$, are set to registers $X_0, X_1, \ldots X_6, X_7$ in sequence as an initial value, respectively. Here, $\alpha^0, \alpha^{-1}, \ldots \alpha^{-6}, \alpha^{-7}$ denote $\alpha i$ multiplication circuits, respectively as in the polynominal calculating circuit A. The respective calculated results are inputted to the respective exclusive OR gates, and the following polynominal is outputted from the output terminal b

$$
\begin{aligned}
\eta(\alpha 0) &= \eta_0 + \eta_1 + \ldots + \eta_6 + \eta_7 \\
&= \eta_0(\alpha^0)^0 + \eta_1(\alpha^{-1})^0 + \ldots + \eta_6(\alpha^{-6})^0 \\
&\quad + \eta_7(\alpha^{-7})^0 \quad\quad\quad\quad\quad \ldots (36)
\end{aligned}
$$

Whenever a single clock BCLK is inputted to each of the registers $X_0, X_1, \ldots X_6, X_7$, the respective registers $X_0, X_1, \ldots X_6, X_7$ store outputs $\eta_0(\alpha^0)^0, \eta_1(\alpha^{-1})^0, \ldots \eta_6(\alpha^{-6})^0, \eta_7(\alpha^{-7})^0$ of respective multiplication circuits $\alpha^0, \alpha^{-1}, \ldots \alpha^{-6}, \alpha^{-7}$, separately. Therefore, the output from the output terminal b is

$$
\begin{aligned}
\eta(\alpha_1) &= \eta_0\alpha^0 + \eta_1\alpha^{-1} + \ldots + \eta_6\alpha^{-6} + \eta_7\alpha^{-7} \\
&= \eta_0(\alpha^0)^1 + \eta_1(\alpha^{-1})^1 + \ldots + \eta_6(\alpha^{-6})^1 \\
&\quad + \eta_7(\alpha^{-7})^1 \quad\quad\quad\quad\quad \ldots (37)
\end{aligned}
$$

In the same way, each value of polynominal $\eta(\alpha i)$ is calculated at each location i.

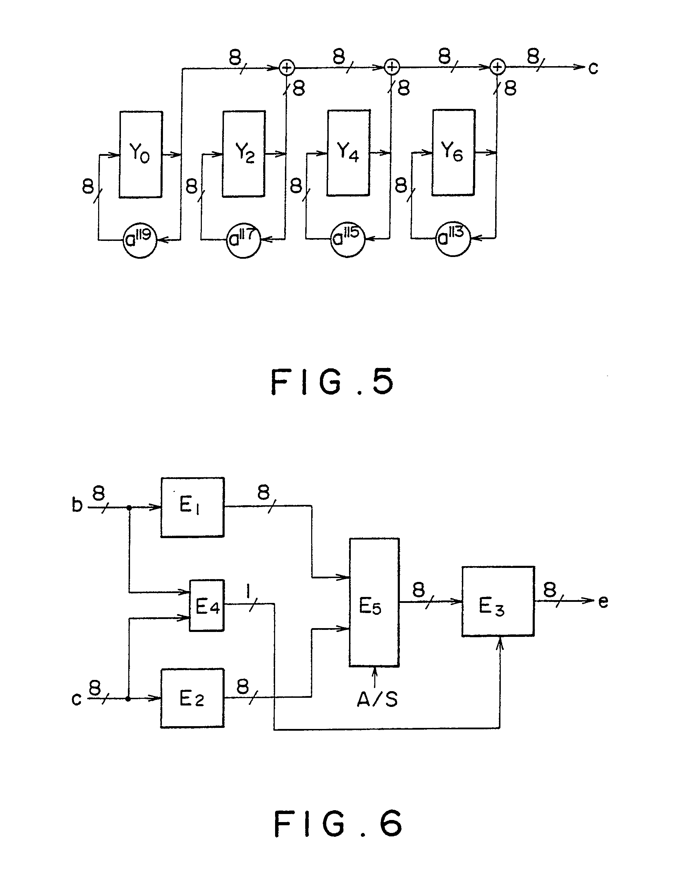

Fig. 5 shows the polynominal calculating circuit C for calculating $Y(\alpha i)$ $(= \sigma'(\alpha i)/\alpha i^{119})$, which is shown in Fig. 1.

First, $\sigma_1, \sigma_3, \ldots \sigma_5, \sigma_7$ are set to registers $Y_0, Y_2, Y_4, Y_6$ in sequence as an initial value, respectively. Here, $\alpha^{119}, \alpha^{117}, \alpha^{115}, \alpha^{113}$ denote $\alpha i$ multiplication circuits, respectively. The respective calculated results are inputted to the respective exclusive OR gates, and the following polynominal is outputted from the output terminal c:

$$
\begin{aligned}
\sigma'(\alpha_0)/\alpha_0^{119} \\
&= \sigma_1 + \sigma_3 + \sigma_5 + \sigma_7 \\
&= \sigma_1(\alpha^{119})^0 + \sigma_3(\alpha^{117})^0 + \sigma_5(\alpha^{113}) \\
&\quad + \sigma_7(\alpha^{113})^0 \quad\quad\quad\quad\quad \ldots (38)
\end{aligned}
$$

Whenever a single clock CCLK is inputted to each of the registers $Y_0, Y_2, Y_4, Y_6$, the respective registers $Y_0, Y_2, Y_4, Y_6$ store outputs $\sigma_1\alpha^{119}, \sigma_3\alpha^{117}, \sigma_5\alpha^{115}, \sigma_7\alpha^{118}$ of the respective multiplication circuits $\alpha^{119}, \alpha^{117}, \alpha^{115}, \alpha^{113}$, separately. Therefore, the output from the output terminal c is

$$
\begin{aligned}
\sigma'(\alpha_1)/\alpha_1^{119} \\
&= \sigma_1\alpha^{119} + \sigma_3\alpha^{117} + \sigma_5\alpha^{115} + \sigma_7\alpha^{113} \\
&= \sigma_1(\alpha^{119})^1 + \sigma_3(\alpha^{117})^1 + \sigma_5(\alpha^{115})^1 \\
&\quad + \sigma_7(\alpha^{113})^1 \quad\quad\quad\quad\quad \ldots (39)
\end{aligned}
$$

In the same way, the following polynominal is outputted from the terminal c at each location i:

$\sigma'(\alpha_i)/\alpha_i^{119}$
$= \sigma_1(\alpha^{119})^i + \sigma_3(\alpha^{117})^i + \sigma_5(\alpha^{115})^i$
$+ \sigma_7(\alpha^{113})^i$ $\quad (40)$

As described above, values of the polynominal $\sigma'(\alpha_i)/\alpha_i^{119}$ can be obtained at each location i.

Fig. 6 shows the Galois field arithmetic circuit D shown in Fig. 1. In Fig. 6, an output terminal b of the polynominal calculating circuit B is connected to a transforming ROM E1 and a detecting circuit E4, and an output terminal c of the polynominal calculating circuit c is connected to a transforming ROM E2 and a detecting circuit E4. When $\alpha^{ib}$ is outputted from the output terminal b and $\alpha^{ic}$ is outputted from the output terminal c, the transforming ROMs E1 and E2 transforms $\alpha^i$ to i, so that ib and ic are outputted respectively, and then both are inputted to an adder/subtracter E5. This adder/subtracter E5 is an arithmetic unit for executing either addition or subtraction in response to a selection signal A/S. When a carrier is generated, 1 is added to the output result so as to be used for addition/subtraction of the exponential character (i.e. characteristic) of the Galois field.

When the adder/subtracter E5 is used as a subtracter, the subtracter E5 outputs a value ib-ic (obtained by subtracting the output ic of the transforming ROM E2 from the output ib of the transforming ROM E1) to a transforming ROM E3. This transforming ROM E3 for transforming i to $\alpha i$ transforms ib-ic to $\alpha^{ib-ic}$ and outputs the transformed value from the output terminal e. This output value corresponds to a value obtained by dividing the output of the output terminal b by that of the output terminal c as follows:

$$\alpha^{ib-ic} = \alpha^{ib} \cdot \alpha^{-ic} = \alpha^{ib}/\alpha^{ic} \qquad (41)$$

However, if the outputs of the output terminals b and c are both 0, since this situation is detected by the detecting circuit E4, 0 is outputted from the transforming ROM E3.

The polynominal calculating circuits A, B and C, the detecting circuit D and the Galois field arithmetic circuit E configured as described above are connected to each other, as shown in Fig. 1. Initial values $\eta 0$, $\eta 1, \ldots \eta 6, \eta 7$; $\sigma 1, \sigma 3, \sigma 5, \sigma 7$; and $\sigma 0, \sigma 1, \ldots \sigma 7, \sigma 8$ are each set to the respective registers X0, X1, ... X6, X7; Y0, Y2, Y4, Y6; and Z0, Z1, ... Z7, Z8 of the polynominal calculating circuit A. Additionally, the same clock ACLK, BCLK, CCLK is supplied to the respective polynominal calculating circuits A, B and C. Further, the number of clocks obtained when 1 is outputted from the output terminal d of the detecting circuit D corresponds to an error location i. At this time, the following error pattern Ei is outputted from the output terminal e of the Galois field arithmetic circuit E.

$$Ei = \eta(\alpha i)/\{\sigma'(\alpha i)/\alpha i^{119}\} \qquad (42)$$

As described above, in the calculating circuit of the present embodiment, it is possible to obtain an error location i and an error pattern Ei simultaneously.

In the above-mentioned embodiment, $\alpha i^k$ is incorporated in $\sigma'(\alpha i)$. However, where $\alpha i^k$ is incorporated in $\eta(\alpha i)$ as in the expression (7), the respective polynominals to be obtained are

$$Ei = \{\alpha i^{119} \cdot \eta(\alpha i)\}/\sigma'(\alpha i) \qquad (43)$$

$$
\begin{aligned}
X(\alpha i) \\
&= \alpha i^{119} \cdot \eta(\alpha i) \\
&= \alpha i^{119}\{\eta_7(\alpha i)^7 + \eta_6(\alpha i)^6 + \ldots + \eta_1(\alpha i) + \eta_0 \\
&= \eta_7(\alpha i)^{126} + \eta_6(\alpha i)^{125} + \ldots + \eta_1(\alpha i)^{120} \\
&\quad + \eta_0(\alpha i)^{119} = \eta_7(\alpha^{-126})^i + \eta_6(\alpha^{-125})^i + \\
&\quad \ldots + \eta_1(\alpha^{-120})^i + \eta_0(\alpha^{-119})^i \qquad \ldots (44)
\end{aligned}
$$

$$
\begin{aligned}
Y(\alpha i) \\
&= \sigma'(\alpha i) \\
&= \sigma_7(\alpha i)^6 + \sigma_5(\alpha i)^4 + \sigma_3(\alpha i)^2 + \sigma_1 \\
&= \sigma_7(\alpha^{-6})^i + \sigma_5(\alpha^{-4})^i + \sigma_3(\alpha^{-2})^i \\
&\quad + \sigma_1(\alpha^0)^i \qquad \ldots (45)
\end{aligned}
$$

Here, the polynominal $X(\alpha i) = (\alpha i^{119} \cdot \eta(\alpha i))$ can be obtained by changing the respective multiplication circuits $\alpha^0$, $\alpha^{-1}$, ... $\alpha^{-6}$, $\alpha^{-7}$ of the polynominal calculating circuit B shown in Fig. 4 to the respective multiplication circuits $\alpha^{-119}$, $\alpha^{-120}$, ... $\alpha^{-125}$, $\alpha^{-126}$.

Further, the polynominal $Y(\alpha i) = (= \sigma'(\alpha i))$ can be obtained by changing the respective multiplication circuits $\alpha^{119}$, $\alpha^{117}$, $\alpha^{115}$, $\alpha^{113}$ of the polynominal calculating circuit c shown in Fig. 5 to the respective multiplication circuits $\alpha^0$, $\alpha^{-2}$, $\alpha^{-4}$, $\alpha^{-5}$. The Galois field arithmetic circuit E for executing the Galois field operation on the basis of these polynominals is the same as that shown in Fig. 6.

Further, if the polynominals are transformed on condition that $k = 1+m$, the expressions (13) to (15) are

$$Ei = \{\alpha_i^{119-m} \cdot \eta(\alpha i)\}/\{\sigma'(\alpha i)/\alpha_i^m\} \qquad (46)$$

$$\begin{aligned}
X(\alpha i) &= \alpha i^{119-m} \cdot \eta(\alpha i) \\
&= \alpha i^{119-m}\{\eta_7(\alpha i)^7 + \eta_6(\alpha i)^6 + \\
&\qquad \dots + \eta_1(\alpha i) + \eta_0\} \\
&= \eta_7(\alpha i)^{126-m} + \eta_6(\alpha i)^{125-m} + \dots + \eta_1(\alpha i)^{120-m} \\
&\qquad + \eta_0(\alpha i)^{119-m} \\
&= \eta_7(\alpha^{m-126})^i + \eta_6(\alpha^{m-125})^i + \\
&\qquad \dots + \eta_1(\alpha^{m-120})^i + \eta_0(\alpha^{m-119})^i \qquad \dots (47)
\end{aligned}$$

$$\begin{aligned}
Y(\alpha i) &= \sigma'(\alpha i)/\alpha_i^m \\
&= \{\sigma_7(\alpha i)^6 + \sigma_5(\alpha i)^4 + \sigma_3(\alpha i)^2 + \sigma_1\}/\alpha_i^m \\
&= \sigma_7(\alpha i)^{6-m} + \sigma_5(\alpha i)^{4-m} + \sigma_3(\alpha i)^{2-m} + \sigma_1(\alpha i)^{-m} \\
&= \sigma_7(\alpha^{m-6})^i + \sigma_5(\alpha^{m-4})^i + \sigma_3(\alpha^{m-2})^i \\
&\qquad + \sigma_1(\alpha^m)^i \qquad \dots (48)
\end{aligned}$$

Here, the polynominal $X(\alpha i) = (\alpha i^{119-m} \cdot \eta(\alpha i))$ can be obtained by changing the respective multiplication circuits, $\alpha^0$, $\alpha^{-1}$, ... $\alpha^{-6}$, $\alpha^{-7}$ of the polynominal calculating circuit B to the respective multiplication circuits $\alpha^{m-119}$, $\alpha^{m-120}$, ... $\alpha^{m-125}$, $\alpha^{m-126}$.

Further, the polynominal $Y(\alpha i) = (\sigma'(\alpha i)/\alpha_i^m)$ can be obtained by changing the respective multiplication circuits $\alpha^{119}$, $\alpha^{117}$, $\alpha^{115}$, $\alpha^{113}$ of the polynominal calculating circuit c to the respective multiplication circuits $\alpha^m$, $\alpha^{m-2}$, $\alpha^{m-4}$, $\alpha^{m-6}$.

As described above, in the circuit according to the present invention, an error location and an error pattern can be both obtained simultaneously at the time when the Chien search operation ends. Therefore, it is possible to reduce the processing time as compared with the conventional method such that only the error location is obtained at the time when the Chien search operation ends and thereafter the error pattern must be further obtained. In addition, in the present invention, the processing speed can be further increased because the syndrome formation and the error location and error pattern formation on the basis of the Euclid's algorithm are executed by means of hardware, not by means of software.

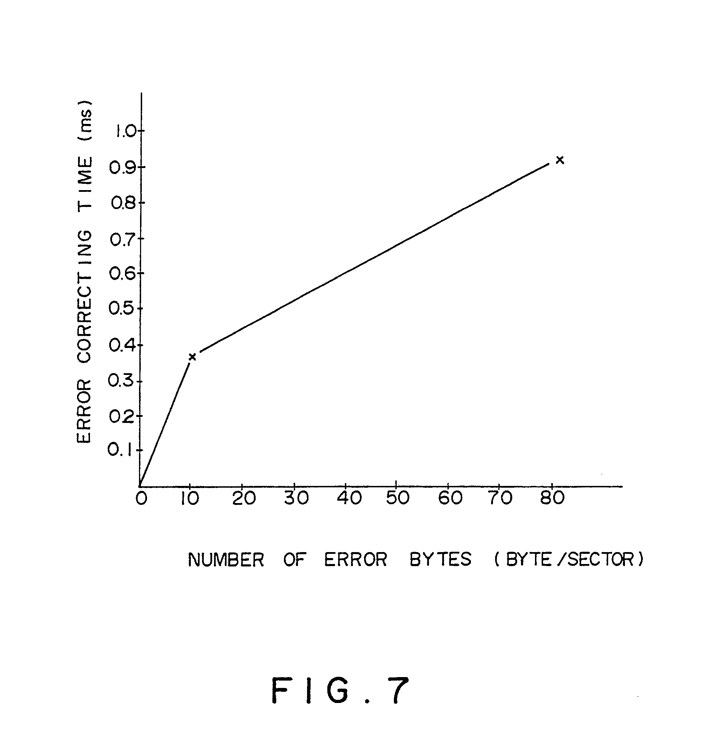

Fig. 7 shows the time required to obtain the error location and the error pattern when the circuit according to the present invention is applied to a 5.25-inch dia. optical disk conforming to the ISO standard in which the data length is 1024 byte/sector and the number of interleaves is 10. Fig. 7 indicates that the error correcting time is 0.95 ms or less when there exists an 8-byte error per interleave, and therefore it is possible to increase the processing speed approximately 100 to 200 times higher than the conventional circuit which requires 120 to 210 ms as shown in Fig. 8. This indicates that it is possible to correct error without causing any idle disk revolutions, in the case of an optical disk with a revolution speed of 1800 r.p.m.

Reference signs in the claims are intended for better understanding and shall not limit the scope.

**Claims**

EP 0 458 285 A1

1. An error location and error pattern calculating circuit by which a numerical value Ei in Euclid's algorithm is expressed as

$$Ei = \alpha i^{k} \cdot \eta(\alpha i)/\sigma'(\alpha i)$$

by a polynominal $\sigma(z)$, a polynominal $\sigma'(z)$ obtained by differentiating the polynominal $\sigma(z)$, a polynominal $\eta(z)$, a numerical value i, Galois field elements $\alpha i$, and an integer k determined by the generator polynominals as $\ell + m$ where $\ell$ and m are both integers, which comprises:

a first polynominal calculating circuit (A) for calculating and outputting the polynominal $\sigma(\alpha i)$;

a detecting circuit (D) for detecting that said first polynominal calculating circuit outputs 0;

a second polynominal calculating circuit (B) for calculating and outputting the polynominal $\alpha i^{\ell} \cdot \eta(\alpha i)$;

a third polynominal calculating circuit (C) for calculating and outputting the polynominal $\sigma'(\alpha i)/\alpha i^{m}$; and

a Galois field arithmetic circuit (E) for executing Galois field operation on the basis of outputs of said second and third polynominal calculating circuits and forming and outputting the numerical value Ei, and wherein a numerical value i obtained when said detecting circuit detects 0 is determined as an error location, and a numerical value Ei corresponding to this numerical value i is determined as an error pattern.

2. The error location and error pattern calculating circuit of claim 1, wherein $\ell = 0$; said second polynominal calculating circuit calculates and outputs the polynominal $\eta(\alpha i)$; and said third polynominal calculating circuit calculates and outputs the polynominal $\sigma'(\alpha i)/\alpha i^{k}$ or $\alpha i^{k}/\sigma'(\alpha i)$.

3. The error location and error pattern calculating circuit of claim 1, wherein $m = 0$; said second polynominal calculating circuit calculates and outputs the polynominal $ai^{k} \cdot \eta(\alpha i)$; and said third polynominal calculating circuit calculates and outputs the polynominal $\sigma'(\alpha i)$.

11

FIG. 1

$$\boxed{\text{START}}$$

101 —

$$M_1(Z) \leftarrow Z^{2t} \qquad M_2(Z) \leftarrow S(Z)$$
$$U_1(Z) \leftarrow 0 \qquad U_2(Z) \leftarrow 0$$
$$U_1'(Z) \leftarrow 1$$

102 —

$$Q(Z) \leftarrow [M_1(Z) / M_2(Z)]$$
$$R(Z) \leftarrow M_1(Z) - M_2(Z) \cdot Q(Z)$$

103 —

$$U_1(Z) \leftarrow Q(Z) \cdot U_1(Z) + U_2(Z)$$
$$U_2(Z) \leftarrow U_1'(Z)$$

104

$$\text{degR}(Z) \leqq t-1$$

NO

105

$$M_1(Z) \leftarrow M_2(Z)$$
$$M_2(Z) \leftarrow R(Z)$$
$$U_1'(Z) \leftarrow U_1(Z)$$

YES

106 —

$$\sigma(Z) \leftarrow U_1(Z) / \delta$$
$$\eta(Z) \leftarrow R(Z) / \delta$$

$$\boxed{\text{END}}$$

# FIG. 2

13

F I G . 3

F I G . 4

14

FIG.5

FIG.6

FIG. 7

FIG . 8

European
Patent Office

EUROPEAN SEARCH
REPORT

Application Number

EP 91 10 8215

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | WO-A-8 809 011 (DIGITAL EQUIPMENT CORPORATION) * page 9, line 19 - page 12, line 4 * * page 15, line 20 - page 17, line 22; figure 3 * | 1-3 | H 03 M 13/00 |
| A | US-A-4 649 541 (C.R. LAHMEYER) * column 8, lines 4 - 35; figures 9, 10 * | 1 | |

TECHNICAL FIELDS
SEARCHED (Int. Cl.5)

H 03 M
G 06 F

The present search report has been drawn up for all claims

| Place of search | Date of completion of search | Examiner |
|---|---|---|
| The Hague | 29 July 91 | VITERBO E. |